# EUROPEAN PATENT SPECIFICATION

(11) **EP 2 600 412 B1**
(45) Date of publication and mention of the grant of the patent: **05.12.2018**
(21) Application number: 11812513.7
(22) Date of filing: 27.07.2011
(51) Int. Cl.: H01L 31/04

(54) **PHOTOELECTRIC CONVERSION DEVICE**
PHOTOELEKTRISCHE UMWANDLUNGSVORRICHTUNG
DISPOSITIF DE CONVERSION PHOTOÉLECTRIQUE

(30) Priority: 29.07.2010 JP 2010170053
(43) Date of publication of application: 05.06.2013
(73) Proprietor: KYOCERA Corporation, Kyoto 612-8501 (JP)
(72) Inventor: OGURI, Seiji, Kyoto, 612 8501 (JP); TANAKA, Isamu, Kyoto, 612 8501 (JP); MATSUSHIMA, Norihiko, Kyoto, 612 8501 (JP); YAMAMOTO, Akio, Kyoto, 612 8501 (JP)
(74) Representative: Viering, Jentschura & Partner mbB Patent- und Rechtsanwälte
(86) International application number: PCT/JP2011/067066
(87) International publication number: WO 2012/014924

(56) References cited:
- WO-A1-2010/027032
- JP-A- 5 055 615
- JP-A- 2001 053 314
- JP-A- 2004 111 664
- JP-A- 2009 076 842
- JP-A- 2010 129 640
- US-A1- 2007 163 637
- ELLMER K ET AL: "Copper indium disulfide solar cell absorbers prepared in a one-step process by reactive magnetron sputtering from copper and indium targets", THIN SOLID F, ELSEVIER, AMSTERDAM, NL, vol. 413, no. 1-2, 24 June 2002 (2002-06-24), pages 92-97, XP004369913, ISSN: 0040-6090, DOI: 10.1016/S0040-6090(02)00355-3
- RAU U ET AL: "Oxygenation and air-annealing effects on the electronic properties of Cu(In,Ga)Se2 films and devices", JOURNAL OF APPLIED PHYSICS, AMERICAN INSTITUTE OF PHYSICS, US, vol. 86, no. 1, 1 July 1999 (1999-07-01), pages 497-505, XP012047900, ISSN: 0021-8979, DOI: 10.1063/1.370758

## Description

### Technical Field

The present invention relates to a photoelectric conversion device.

### Background Art

As photoelectric conversion devices, there are devices including a light-absorbing layer comprised of a chalcopyrite-based compound semiconductor of group I-III-VI such as CIGS.

Documents "Oxygenation and air-annealing effects on the electronic properties of Cu(In,Ga)Se2 films and devices, U. Rau et al., J. Appl. Phys. Vol. 86 N. 1 p497 (XP12047900), patent publication US2007/0163637 and "Copper indium disulfide solar cell absorbers prepared in a one-step process by reactive magnetron sputtering from copper and indium targets", K. Ellmer et al., Thin Solid Films 413 (2002) 92-97 (XP4369913) disclose such devices.

Japanese Patent Application Laid-Open No. 2000-156517 discloses an example in which a light-absorbing layer comprised of a group I-III-VI compound semiconductor is provided on a backside electrode formed on a substrate. A buffer layer comprised of ZnS, CdS, or the like and a transparent conductive film comprised of ZnO or the like are formed on the light-absorbing layer.

### Summary of the Invention

### Problem to be Solved by the Invention

In those photoelectric conversion devices, the diffusion length of minority carriers (electrons) generated in the light-absorbing layer is reduced due to a large number of defects present in a light-absorbing layer. As a result, in some cases, the minority carriers disappear due to the recombination with, for example, holes before being extracted by electrodes or the like. In particular, in a case where the light-absorbing layer contains voids, a relatively large number of defects as described above are present on the surface facing the voids. Therefore, minority carriers are prone to disappear in the vicinity of the voids, which may lead to a case in which photoelectric conversion efficiency decreases.

An object of the present invention is to reduce the occurrence of the recombination of minority carriers due to defects in a light-absorbing layer, to thereby improve photoelectric conversion efficiency.

### Means to Solve the Problem

A photoelectric conversion device according to an embodiment of the present invention comprises a light-absorbing layer including a chalcopyrite-based compound semiconductor of group I-III-VI and oxygen. The light-absorbing layer includes voids therein. In the present embodiment, an atomic concentration of oxygen in the vicinity of the voids is higher than an average atomic concentration of oxygen in the light-absorbing layer.

### Effects of the Invention

According to the photoelectric conversion device of the embodiment of the present invention, defects in the vicinity of the voids in the light-absorbing layer are likely to be filled with oxygen efficiently. This reduces the occurrence of recombination of carriers, leading to improvement of photoelectric conversion efficiency.

### Brief Description of Drawings

FIG. 1 is a perspective view showing an example of an embodiment of a photoelectric conversion device of the present invention.
FIG. 2 is a cross-sectional view showing the example of the embodiment of the photoelectric conversion device of the present invention.
FIG. 3 is a schematic cross-sectional view for describing the embodiment of the photoelectric conversion device of the present invention.
FIG. 4 is a schematic cross-sectional view for describing another embodiment of the photoelectric conversion device of the present invention.

### Embodiments for Carrying Out the Invention

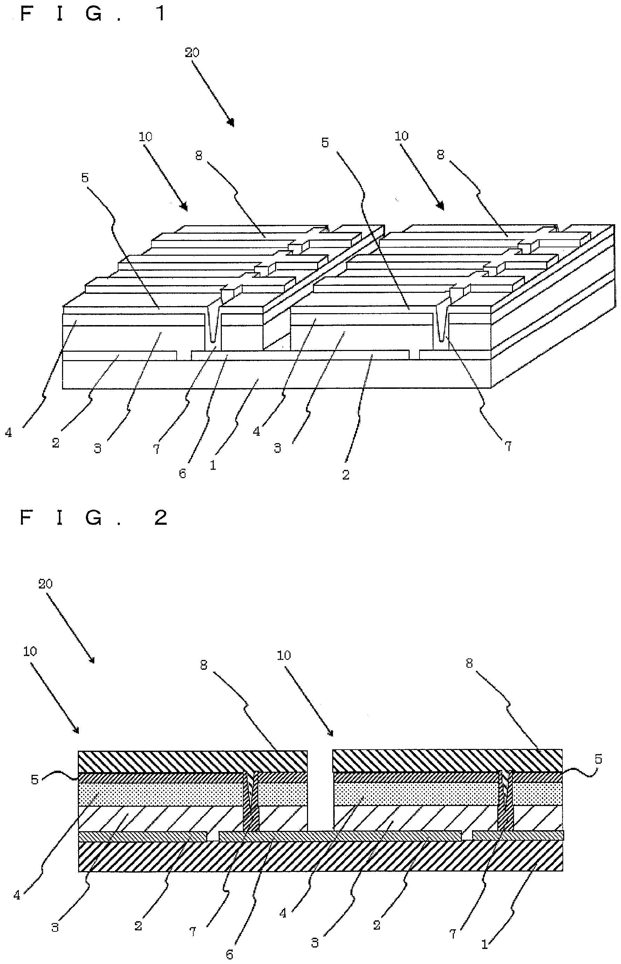

As shown in FIGS. 1 and 2, a photoelectric conversion device 10 according to an embodiment of the present invention comprises a substrate 1, a first electrode layer 2, a light-absorbing layer 3, a buffer layer 4, and a second electrode layer 5. The photoelectric conversion device 10 is provided with a third electrode layer 6 provided to be spaced from the first electrode layer 2 on the substrate 1 side of the light-absorbing layer 3. The neighboring photoelectric conversion devices 10 are electrically connected to each other by a connection conductor 7. That is, the second electrode layer 5 of the one photoelectric conversion device 10 and the third electrode layer 6 of the other photoelectric conversion device 10 are connected by the connection conductor 7. The third electrode layer 6 also serves as the first electrode layer 2 of the neighboring photoelectric conversion device 10. As a result, the neighboring photoelectric conversion devices 10 are connected to each other in series. The connection conductor 7 is provided so as to separate the light-absorbing layer 3 and the buffer layer 4 in one photoelectric conversion device 10. Accordingly, in the photoelectric conversion device 10, photoelectric conversion is performed by the light-absorbing layer 3 and the buffer layer 4 that are sandwiched between the first electrode layer 2 and the second electrode layer 5. Alternatively, a collector electrode 8 may be provided on the second electrode layer 5 as in the present embodiment.

The substrate 1 serves to support the photoelectric conversion devices 10. Examples of the material used for the substrate 1 include glass, ceramics resins and the like.

The first electrode layer 2 and the third electrode layer 6 are formed of, for example, molybdenum (Mo), aluminium (Al), titanium (Ti), gold (Au) or the like. The first electrode layer 2 and the third electrode layer 6 are formed on the substrate 1 by, for example, a sputtering method or a vapor deposition method.

The light-absorbing layer 3 absorbs light and performs photoelectric conversion in cooperation with the buffer layer 4. The light-absorbing layer 3 includes a chalcopyrite-based compound semiconductor and is provided on the first electrode layer 2 and the third electrode layer 6. Here, the chalcopyrite-based compound semiconductor means a compound semiconductor (also referred to as a CIS-based compound semiconductor) of a group I-B element (also referred to as a group 11 element), a group III-B element (also referred to as a group 13 element), and a group VI-B element (also referred to as a group 16 element). Examples of the chalcopyrite-based compound semiconductor of group I-III-VI include Cu(In, Ga)Se₂ (also referred to as CIGS), Cu(In, Ga)(Se, S)₂ (also referred to as CIGSS), and CuInS₂ (also referred to as CIS). Note that Cu(In, Ga)Se₂ is a compound mainly comprised of Cu, In, Ga, and Se. Further, Cu(In, Ga)(Se, S)₂ is a compound mainly comprised of Cu, In, Ga, Se, and S.

It suffices that the light-absorbing layer 3 has a thickness of, for example, 1 to 2.5 µm. This increases photoelectric conversion efficiency.

The light-absorbing layer 3 contains oxygen in addition to a chalcopyrite-based compound semiconductor. The oxygen described above serves to fill the defects present in the chalcopyrite-based compound semiconductor. The defect means a portion in which atoms are desorbed from a partial site of a chalcopyrite structure. The oxygen can enter the portion from which the atoms are desorbed, to thereby fill the defects. In other words, the portion in which atoms are desorbed from a partial site of the chalcopyrite structure is substituted by oxygen. This enables to fill the defects with oxygen, leading to a reduction of the occurrence of recombination of carriers.

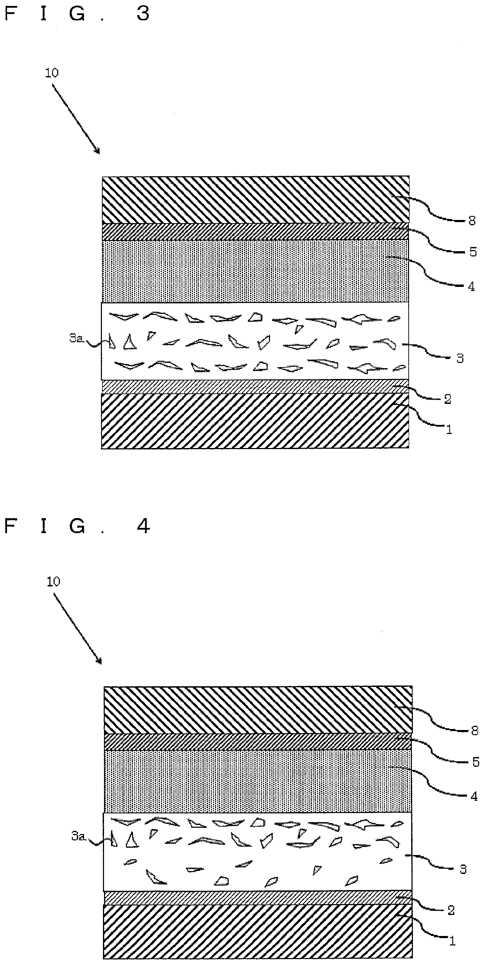

As shown in FIG. 3, meanwhile, the light-absorbing layer 3 includes a plurality of voids 3a. Those voids 3a mitigate, for example, a shock imposed on the light-absorbing layer 3 from the outside. As a result, cracks generated in the light-absorbing layer 3 by, for example, the shock as described above are reduced. Further, the voids 3a allow the light entering the light-absorbing layer 3 to be scattered. This makes it easy to confine light in the light-absorbing layer 3, leading to enhanced photoelectric conversion efficiency. The void 3a has, for example, a polygonal shape, circular shape, oval shape or the like in cross section in the thickness direction of the light-absorbing layer 3. It suffices that the occupancy of the voids 3a in the light-absorbing layer 3 (percentage of voids in the light-absorbing layer 3) is 10 to 80%. The occupancy may be 30 to 60%. This enables the light-absorbing layer 3 to keep the rigidity thereof while mitigating the shocks or the like described above.

The light-absorbing layer 3 has a higher atomic concentration of oxygen in the vicinity of the voids 3a than the average atomic concentration of oxygen in the light-absorbing layer 3. Therefore, in the present embodiment, a large number of defects present on the surface of the light-absorbing layer 3 facing the voids 3a can be filled with oxygen efficiently. This enables to reduce the occurrence of recombination of carriers, leading to improved photoelectric conversion efficiency.

In the light-absorbing layer 3, a considerable increase in atomic concentration of oxygen described above results in that, in some cases, a large amount of oxygen is present also in the portion other than the portion where the defects are present. In such cases, oxygen per se may become defects. Therefore, it suffices that the average atomic concentration of oxygen of the light-absorbing layer 3 is 1 to 5 atomic%. The atomic concentration of oxygen in the above-mentioned range enables to increase photoelectric conversion efficiency. Meanwhile, the average atomic concentration of oxygen of the light-absorbing layer 3 may be 1 to 3 atomic%. The above-mentioned range enables to fill the defects present on the surface of the light-absorbing layer 3 while reducing the generation of defects due to oxygen per se, leading to more enhanced photoelectric conversion efficiency. The average atomic concentration of oxygen in the light-absorbing layer 3 can be obtained as an average value of the atomic concentrations measured at the parts of arbitrary ten spots in the light-absorbing layer 3.

Meanwhile, the atomic concentration of oxygen in the vicinity of the voids 3a of the light-absorbing layer 3 is higher than the average atomic concentration of oxygen of the light-absorbing layer 3 by approximately 0.1 to 3 atomic%. That is, in the light-absorbing layer 3 controlled to fall within the range of the above-mentioned average atomic concentration of oxygen, the generation of excessive defects due to oxygen can be reduced while appropriately filling the defects present on the surface of the light-absorbing layer 3 facing (fronting on) the voids 3a with oxygen.

The vicinity of the voids 3a refers to the range within 100 nm in the depth direction of the light-absorbing layer 3 from the surface facing the voids 3a. The atomic concentration of oxygen in the vicinity of the voids 3a is obtained as an average value of the atomic concentrations measured at the parts of arbitrary ten spots within the above-mentioned range.

The atomic concentration of oxygen in the light-absorbing layer 3 can be measured by, for example, X-ray photoelectron spectroscopy (XPS), Auger electron spectroscopy (AES), secondary ion mass spectroscopy (SIMS) or the like. In those methods, measurements are performed while shaving the light-absorbing layer 3 in the depth direction by a sputtering method.

For example, the atomic concentration of oxygen of the light-absorbing layer 3 was measured by secondary ion mass spectroscopy which shaves the light-absorbing layer 3 in the depth direction by a sputtering method while irradiating the light-absorbing layer 3 with an ion beam of cesium, with the result that the average atomic concentration of oxygen in the light-absorbing layer 3 was 1.3 atomic%. The atomic concentration of oxygen in the vicinity of the voids 3a of the light-absorbing layer 3 was 1.7 atomic%. In the photoelectric conversion device 10 as described above, the generation of excessive defects due to oxygen can be reduced while appropriately filling the defects present on the surface of the light-absorbing layer 3 facing the voids 3a with oxygen. This enhances photoelectric conversion efficiency.

Next, an example of the method of manufacturing the light-absorbing layer 3 is described. First, the materials of the light-absorbing layer 3 are described. The material solution of the light-absorbing layer 3 may contain, for example, a group I-B metal, a group III-B metal, a chalcogen element-containing organic compound, and a Lewis base organic solvent. The group I-B metal and the group III-B metal can dissolve well in a solvent containing the chalcogen element-containing organic compound and the Lewis base organic solvent (hereinafter also called as a mixed solvent S). The mixed solvent S as described above enables to produce a material solution in which the concentration of the total of the group I-B metal and the group III-B metal to the mixed solvent S is 6 wt% or higher. The use of the mixed solvent S as described above increases the solubility of the above-mentioned metals, so that a high-concentration material solution can be obtained. Next, the material solution is described in detail.

The chalcogen element-containing organic compound refers to an organic compound containing a chalcogen element. The chalcogen element refers to S, Se, or Te among the group VI-B elements. In a case where the chalcogen element is S, examples of the chalcogen element-containing organic compound include thiol, sulfid, disulfid, thiophene, sulfoxide, sulfone, thioketone, sulfonic acid, sulfonate ester, sulfonic acid amide and the like. Among the compounds above, thiol, sulfid, disulfid, and the like is likely to form a complex with a metal. If the chalcogen element-containing organic compound includes a phenyl group, the chalcogen element-containing organic compound can enhance application properties of the material solution. Examples of the above-mentioned compound include, for example, thiophenol, diphenyl sulfide, and derivatives thereof.

In a case where the chalcogen element is Se, examples of the chalcogen element-containing organic compound include selenol, selenide, diselenide, selenoxide, selenone and the like. Among the compounds above, selenol, selenide, diselenide and the like is likely to form a complex with a metal. If the chalcogen element-containing organic compound is phenylselenol, phenyl selenide, diphenyl diselenide, and derivatives thereof, the chalcogen element-containing organic compound can enhance application properties of the material solution.

In a case where the chalcogen element is Te, examples of the chalcogen element-containing organic compound include tellurol, telluride, and ditelluride.

The Lewis base organic solvent is an organic solvent containing a substance that may be a Lewis group. Examples of the Lewis base organic solvent include pyridine, aniline, triphenyl phosphine, and derivatives thereof. If the boiling point of the Lewis base organic solvent is 100°C or higher, the Lewis base organic solvent can enhance application properties of the material solution.

The group I-B metal and the chalcogen element-containing organic compound may be chemically bonded to each other. Further, the group III-B metal and the chalcogen element-containing organic compound may be chemically bonded to each other. Still further, the chalcogen element-containing organic compound and the Lewis base organic solvent may be chemically bonded to each other. Through the chemical bonds as described above, a higher-concentration material solution in which the metal occupies 8 wt% or higher can be prepared more easily. Examples of the above-mentioned chemical bonds include coordinate bond between respective elements. Such chemical bond can be confirmed by, for example, a nuclear magnetic resonance (NMR) technique. In the NMR technique, the chemical bond between the group I-B metal and the chalcogen element-containing organic compound can be detected as a peak shift of multinuclear NMR of a chalcogen element. The chemical bond between the group III-B metal and the chalcogen element-containing organic compound can be detected as a peak shift of multinuclear NMR of a chalcogen element. The chemical bond between the chalcogen element-containing organic compound and the Lewis base organic solvent can be detected as a peak shift resulting from an organic solvent. It suffices that the number of moles of chemical bond between the group I-B metal and the chalcogen element-containing organic compound falls within the range of 0.1 to 10 times the number of moles of chemical bond between the chalcogen element-containing organic compound and the Lewis base organic solvent.

The mixed solvent S may be prepared by mixing the chalcogen element-containing organic compound and the Lewis base organic solvent together so as to be liquid at a room temperature. As a result, the mixed solvent S can be handled easily. For example, the chalcogen element-containing organic compound in an amount of 0.1 to 10 times the amount of the Lewis base organic solvent may be mixed thereto. Accordingly, the above-mentioned chemical bond can be formed excellently, and a high-concentration solution of a group I-B metal and a group III-B metal can be obtained.

The material solution is obtained by directly dissolving the group I-B metal and the group III-V metal in the mixed solvent S. The method as described above can reduce the inclusion of impurities other than the components of a compound semiconductor in the light-absorbing layer 3. Note that any of the group I-B metal and the group III-B metal may be a metal salt. Here, directly dissolving a group I-B metal and a group III-B metal in the mixed solvent S refers to directly incorporating the raw metal of a single metal or the raw metal of an alloy in the mixed solvent S to be dissolved. As a result, the raw metal of a single metal or the raw metal of an alloy is not required to be once changed into another compound (for example, metal salt such as a chloride) and then be dissolved in a solvent. Therefore, the method as describe above can simplify the steps and reduce the inclusion of impurities other than the elements composing the light-absorbing layer 3 in the light-absorbing layer 3. This enhances the purity of the light-absorbing layer 3.

The group I-B metals include Cu and/or Ag. The group I-B metal may contain one element or two or more elements. In a case where two or more elements of group I-B metals are used, a mixture of two or more elements of group I-B metals may be dissolved in the mixed solvent S at one time. Meanwhile, the group I-B metals of the corresponding elements may be individually dissolved in the mixed solvent S and then mixed together.

The group III-B metals include Ga and/or In. The group III-B metal may contain one element or two or more elements. In a case where two or more elements of group III-B metals are used, the mixture containing two or more elements of group III-B metals may be dissolved in the mixed solvent S at one time. Meanwhile, the group III-B metals of the corresponding elements may be individually dissolved in the mixed solvent S and then mixed together.

Next, the steps of applying and baking a material solution are described. First, a material solution of a chalcopyrite-based compound semiconductor containing a group I-B element, a group III-B element, and a group VI-B element is applied onto the substrate 1 provided with the first electrode layer 2, to thereby form a first applied film (Step A1). Then, the first applied film is heat-treated, to thereby form a first precursor (Step A2). The temperature for forming the first precursor in Step A2 is 250 to 350°C. Then, the first precursor is heated under an oxygen atmosphere, to thereby form a first semiconductor layer (Step A3). The temperature for forming the first semiconductor layer in Step A3 is 400 to 600°C. Then, the material solution of a chalcopyrite-based compound semiconductor containing the group I-B element, the group III-B element, and the group VI-B element is applied onto the first semiconductor layer, to thereby form a second applied film (Step A4). Then, the second applied film is heat-treated under an oxygen atmosphere, to thereby form a second precursor (Step A5). The temperature for forming the second precursor in Step A5 is 250 to 350°C. Then, the second precursor is heated under an atmosphere including the group VI-B element or an inert atmosphere of nitrogen, argon, or the like, to thereby form a second semiconductor layer (Step A6). The temperature for forming the second semiconductor layer in Step A6 is 400 to 600°C. Then, the material solution of a chalcopyrite-based compound semiconductor containing the group I-B element, the group III-B element, and the group VI-B element is applied onto the second semiconductor layer, to thereby form a third applied film (Step A7). Then, the third applied film is heat-treated under an oxygen atmosphere, to thereby form a third precursor (Step A8). The temperature for forming the third precursor in Step A8 is 250 to 350°C. Then, the third precursor is heated under an atmosphere including the group VI-B element or an inert atmosphere of nitrogen, argon, or the like, to thereby form a third semiconductor layer (Step A9). The temperature for forming the third semiconductor layer in Step A9 is 400 to 600°C. The light-absorbing layer 3 is formed through the steps described above.

The voids 3a of the light-absorbing layer 3 tend to occur in the steps of baking the first to third precursors (Steps A3, A6, and A9). Relatively a large number of voids 3a of the light-absorbing layer 3 serve as open pores communicating with the outside air. Accordingly, in the manufacturing steps above, through the introduction of oxygen in the baking step in which the voids 3a tend to occur, oxygen present in the outside air is likely to come into contact with the surface of the light-absorbing layer 3 facing the voids 3a in the formation of the voids 3a. Therefore, in the manufacturing steps described above, the atomic concentration of oxygen in the vicinity of the voids 3a of the light-absorbing layer 3 is higher than the average atomic concentration of oxygen in the whole of the light-absorbing layer 3. It suffices that an introduction amount of oxygen is, for example, approximately 50 to 100 ppm. Meanwhile, the occupancy of the voids 3a in the semiconductor layer of the light-absorbing layer 3 can be adjusted through control of a heat-treatment temperature in the steps of heat-treating the first to third precursors (Steps A2, A5, and A8).

In a case of manufacturing the light-absorbing layer 3 by laminating three or more semiconductor layers, for example, Steps A1 to A9 described above may be repeated. Meanwhile, in a case of forming the light-absorbing layer 3 of one or two layers of semiconductor layers, Steps A1 to A3 or Steps A1 to A6 may be used.

The grain boundary of a chalcopyrite-based compound semiconductor is exposed on the surface of the light-absorbing layer 3 facing the voids 3a. The recombination of carriers, that is, the recombination of electrons and holes tends to occur at the grain boundary as described above. Therefore, description is given below of a manner in which the contents of various elements contained in the light-absorbing layer 3 in the vicinity of the voids 3a are varied to reduce the occurrence of recombination of electrons and holes at the grain boundary.

As an example of the above-mentioned manner, the atomic concentration of copper of the light-absorbing layer 3 in the vicinity of the voids 3a is made lower than the average atomic concentration of copper in the light-absorbing layer 3. In such a manner, the energy level of a valence band formed of copper and selenium is lower in the vicinity of the voids 3a. As a result, the holes are unlikely to remain in the vicinity of the voids 3a, leading to a reduction of the occurrence of recombination of electrons and holes. It suffices that on this occasion, the atomic concentration of copper of the light-absorbing layer 3 in the vicinity of the voids 3a is lower than the average atomic concentration of copper in the light-absorbing layer 3 by 0.1 to 5 atomic%. Accordingly, the chalcopyrite structure can be kept while further reducing the occurrence of recombination described above. It suffices that the average atomic concentration of copper in the light-absorbing layer 3 is 20 to 25 atomic%.

For example, the atomic concentration of copper of the light-absorbing layer 3 was measured by secondary ion mass spectroscopy which shaves the light-absorbing layer 3 in the depth direction by a sputtering method while irradiating the light-absorbing layer 3 with an ion beam of cesium, with the result that the average atomic concentration of copper in the light-absorbing layer 3 was 23 atomic%. The atomic concentration of copper in the vicinity of the voids 3a of the light-absorbing layer 3 was 20 atomic%. In the photoelectric conversion device 10 as described above, the occurrence of recombination described above can be reduced. This leads to a further increase of photoelectric conversion efficiency. As an example of the method of manufacturing the light-absorbing layer 3 as described above, it suffices that an etching process of selectively removing copper or an alloy of copper and selenium is performed on the light-absorbing layer 3 manufactured through Steps A1 to A9. Examples of the above-mentioned method include the method of soaking the light-absorbing layer 3 in ammonia water that serves as an etching solution and introducing the etching solution into the voids 3a, to thereby etch the alloy or the like described above. This enables to reduce the concentration of copper in the vicinity of the voids 3a.

The light-absorbing layer 3 may have a lower atomic concentration of selenium of the light-absorbing layer 3 in the vicinity of the voids 3a than an average atomic concentration of selenium in the light-absorbing layer 3. In such a manner, the energy level of the valence band formed of copper and selenium is lower in the vicinity of the voids 3a. As a result, the holes are unlikely to remain in the vicinity of the voids 3a, which reduces the occurrence of recombination of electrons and holes. It suffices that on this occasion, the atomic concentration of selenium of the light-absorbing layer 3 in the vicinity of the voids 3a is lower than the average atomic concentration of selenium in the light-absorbing layer 3 by 0.1 to 5 atomic%. Accordingly, embrittlement of a CIGS film and a reduction of adhesion at an interface between CIGS and Mo due to the presence of an excessive amount of selenium can be reduced while further reducing the occurrence of recombination described above. It suffices that the average atomic concentration of selenium in the light-absorbing layer 3 is 45 to 55 atomic%.

For example, the atomic concentration of selenium of the light-absorbing layer 3 was measured by secondary ion mass spectroscopy which shaves the light-absorbing layer 3 in the depth direction by a sputtering method while irradiating the light-absorbing layer 3 with an ion beam of cesium, with the result that the average atomic concentration of selenium in the light-absorbing layer 3 was 48 atomic%. The atomic concentration of selenium in the vicinity of the voids 3a of the light-absorbing layer 3 was 44 atomic%. In the photoelectric conversion device 10 as described above, the reliability of the light-absorbing layer 3 can be improved while reducing the occurrence of recombination described above. This leads to a further increase of photoelectric conversion efficiency. As an example of the method of manufacturing the light-absorbing layer 3 as described above, it suffices that an etching process of selectively removing an alloy of copper and selenium is performed on the light-absorbing layer 3 manufactured through Steps A1 to A9. Examples of the above-mentioned method include the method of soaking the light-absorbing layer 3 in ammonia water that serves as an etching solution and introducing the etching solution into the voids 3a, to thereby etch the alloy or the like described above. This enables to reduce the concentration of selenium in the vicinity of the voids 3a.

Meanwhile, the light-absorbing layer 3 may have a higher atomic concentration of selenium of the light-absorbing layer 3 in the vicinity of the voids 3a than an average atomic concentration of selenium in the light-absorbing layer 3. In such a manner, the energy level of the conduction band formed of a group III element and selenium is higher in the vicinity of the voids 3a. As a result, the electrons are unlikely to remain in the vicinity of the voids 3a, which reduces the occurrence of recombination of electrons and holes. It suffices that on this occasion, the atomic concentration of selenium of the light-absorbing layer 3 in the vicinity of the voids 3a is higher than an average atomic concentration of selenium in the light-absorbing layer 3 by 1 to 5 atomic%. Accordingly, embrittlement of a CIGS film and a reduction of adhesion at an interface between CIGS and Mo due to the presence of an excessive amount of selenium can be reduced while further reducing the occurrence of recombination described above. It suffices that the average atomic concentration of selenium in the light-absorbing layer 3 is 45 to 55 atomic%.

For example, the atomic concentration of selenium of the light-absorbing layer 3 was measured by secondary ion mass spectroscopy which shaves the light-absorbing layer 3 in the depth direction by a sputtering method while irradiating the light-absorbing layer 3 with an ion beam of cesium, with the result that the average atomic concentration of selenium in the light-absorbing layer 3 was 48 atomic%. The atomic concentration of selenium in the vicinity of the voids 3a of the light-absorbing layer 3 was 52 atomic%. In the photoelectric conversion device 10 as described above, the reliability of the light-absorbing layer 3 can be improved while reducing the occurrence of recombination described above. This leads to a further increase of photoelectric conversion efficiency. As an example of the method of manufacturing the light-absorbing layer 3 as described above, it suffices that a heat treatment is performed again under a selenium atmosphere after each of Steps A3, A6, and A9 described above.

The light-absorbing layer 3 may have a higher atomic concentration of gallium of the light-absorbing layer 3 in the vicinity of the voids 3a than an average atomic concentration of gallium in the light-absorbing layer 3. In such a manner, oxygen tends be localized in the vicinity of the voids 3a. Therefore, defects in the vicinity of the voids 3a can be filled with oxygen efficiently. It suffices that on this occasion, the atomic concentration of gallium of the light-absorbing layer 3 in the vicinity of the voids 3a is higher than the average atomic concentration of gallium in the light-absorbing layer 3 by 0.1 to 2 atomic%. This enables to accelerate the localization of oxygen described above. It suffices that the average atomic concentration of gallium in the light-absorbing layer 3 is 5 to 15 atomic%.

For example, the atomic concentration of gallium of the light-absorbing layer 3 was measured by secondary ion mass spectroscopy which shaves the light-absorbing layer 3 in the depth direction by a sputtering method while irradiating the light-absorbing layer 3 with an ion beam of cesium, with the result that the average atomic concentration of gallium in the light-absorbing layer 3 was 8.5 atomic%. The atomic concentration of gallium in the vicinity of the voids 3a of the light-absorbing layer 3 was 10 atomic%. In the photoelectric conversion device 10 as described above, the reliability of the light-absorbing layer 3 can be improved while reducing the occurrence of recombination described above. This leads to a further increase of photoelectric conversion efficiency. Examples of the method of manufacturing the light-absorbing layer 3 as described above include the method of heating under an atmosphere which contains 50 to 100 ppm moisture in the steps of heat-treating the first to third precursors (Steps A2, A5, and A8). In this manufacturing method, volatilization of gallium or a compound containing gallium in the vicinity of the voids 3a can be reduced. This relatively increases the atomic concentration of gallium of the light-absorbing layer 3 in the vicinity of the voids 3a compared with the part other than the vicinity of the voids 3a.

It suffices that gallium is present as a gallium oxide in the light-absorbing layer 3. This enhances a passivation effect in the vicinity of the voids 3a, leading to an improvement of reliability. The gallium oxide may be amorphous. This enables to reduce the rigidity of the light-absorbing layer 3 in the vicinity of the voids 3a, leading to further enhancement of an effect of mitigating a stress by the voids 3a.

The atomic concentration of copper, selenium, and gallium can be measured also by X-ray photoelectron spectroscopy or Auger electron spectroscopy. The average atomic concentration of each element in the light-absorbing layer 3 can be obtained as an average value of the atomic concentrations measured at parts of arbitrary ten spots in the light-absorbing layer 3. The atomic concentration of each element in the vicinity of the voids 3a can be obtained as an average value of the atomic concentrations measured at parts of arbitrary ten spots within the range in the vicinity of the voids 3a.

The voids 3a shown in FIG. 3 are distributed almost uniformly inside the light-absorbing layer 3, which may not be almost uniformly. For example, as shown in FIG. 4, the light-absorbing layer 3 may be made to have lower percentages of voids on the first electrode layer 2 side and the second electrode layer 5 side than the percentage of voids on the buffer layer 4 side. In such a manner, the light-absorbing layer 3 on the first electrode layer 2 side and the second electrode layer 5 side is more densified, which enables to increase the adhesion with the first electrode layer 2 and the second electrode layer 5.

The buffer layer 4 is formed on the light-absorbing layer 3. The buffer layer 4 refers to a semiconductor layer that forms a heterojunction (pn junction) with the light-absorbing layer 3. Therefore, a pn junction is formed at an interface between the light-absorbing layer 3 and the buffer layer 4 or in the vicinity of the interface. If the light-absorbing layer 3 is a p-type semiconductor, the buffer layer 4 is an n-type semiconductor. If the buffer layer has a resistivity of 1 Ω·cm or more, a current leakage can be reduced further. Examples of the buffer layer 4 include CdS, ZnS, ZnO, In₂Se₃, In(OH, S), (Zn, In)(Se, OH), (Zn, Mg)O and the like. The buffer layer 4 is formed by, for example, a chemical bath deposition (CBD) method or the like. Note that In(OH, S) is a compound mainly comprised of In, OH, and S. (Zn, In)(Se, OH) is a compound mainly comprised of Zn, In, Se, and OH. (Zn, Mg)O is a compound mainly comprised of Zn, Mg, and O. If the buffer layer 4 is light transmissive for the wavelength region of the light absorbed by the light-absorbing layer 3, the buffer layer 4 can enhance the light absorption efficiency in the light-absorbing layer 3.

In a case where the buffer layer 4 contains indium (In), the second electrode layer 5 may contain an indium oxide. This enables to reduce a change of conductivity due to the interdiffusion of elements between the buffer layer 4 and the second electrode layer 5. Further, the light-absorbing layer 3 may be formed of a chalcopyrite-based material containing indium. In such a manner, the light-absorbing layer 3, the buffer layer 4, and the second electrode layer 5 contain indium, whereby changes of conductivity and carrier concentration due to the interdiffusion of elements between layers can be reduced.

If the buffer layer 4 contains the group III-VI compound as a main component, the moisture resistance of the photoelectric conversion device 10 can be improved. Note that the group III-VI compound refers to a compound of a group III-B element and a group VI-B element. The fact that a group III-VI compound is included as a main component indicates that the concentration of the group III-VI compound in the buffer layer 4 is 50 mol% or more. Further, the concentration of the group III-VI compound in the buffer layer 4 may be 80 mol% or more. The buffer layer 4 may contain Zn at 50 atomic% or less. This enables to improve the moisture resistance of the photoelectric conversion device 10. Further, the buffer layer 4 may contain Zn at 20 atomic% or less.

It suffices that the buffer layer 4 has a thickness of, for example, 10 to 200 nm or 100 to 200 nm. This enables to suppress a reduction of photoelectric conversion efficiency under high-temperature and high-humidity conditions.

The second electrode layer 5 is a transparent conductive film comprised of indium tin oxide (ITO), ZnO, or the like and having a thickness of 0.05 µm to 3 µm. The second electrode layer 5 is formed by a sputtering method, a vapor deposition method, a chemical vapor deposition (CVD) method or the like. The second electrode layer 5 is a layer having an electric resistivity lower than that of the buffer layer 4 and serves to extract the charges generated in the light-absorbing layer 3. If the second electrode layer 5 has a resistivity less than 1Ω·cm and a sheet resistance of 50 Ω/□ or less, charges can be extracted well.

In order to further enhance the absorption efficiency in the light-absorbing layer 3, the second electrode layer 5 may have high light permeability for the light absorbed in the light-absorbing layer 3. The second electrode layer 5 may have a thickness of 0.05 to 0.5 µm. Accordingly, the second electrode layer 5 can enhance light permeability and reduce light reflection. In addition, the second electrode layer 5 can enhance a light scattering effect and transmit the current generated by photoelectric conversion well. If the refractive index is almost the same between the second electrode layer 5 and the buffer layer 4, light reflection at the interface between the second electrode layer 5 and the buffer layer 4 can be reduced.

The second electrode layer 5 may include a group III-VI compound as a main component. This improves humidity resistance of the photoelectric conversion device 10. The fact that a group III-VI compound is included as a main component indicates that the concentration of the group III-VI compound in the second electrode layer 5 is 50 mol% or more. Further, the concentration of the group III-VI compound in the second electrode layer 5 may be 80 mol% or more. Sill further, the concentration of Zn in the second electrode layer 5 may be 50 atomic% or more. This improves humidity resistance of the photoelectric conversion device 10. The concentration of Zn in the second electrode layer 5 may be 20 atomic% or less.

In the photoelectric conversion device 10, the portion including the buffer layer 4 and the second electrode layer 5, that is, the portion sandwiched between the light-absorbing layer 3 and the collector electrode 8 may include a group III-VI compound as a main component. The fact that a group III-VI compound is included as a main component indicates that a group III-VI compound (in a case of a plurality of kinds of group III-VI compounds, the total thereof) is 50 mol% or more of the compounds constituting the portion including the buffer layer 4 and the second electrode layer 5. Further, the group III-VI compound may be 80 mol% or more. The concentration of Zn in the portion including the buffer layer 4 and the second electrode layer 5 may be 50 atomic% or less. This improves humidity resistance of the photoelectric conversion device 10. Further, the concentration of Zn in the portion including the buffer layer 4 and the second electrode layer 5 may be 20 atomic% or less.

The photoelectric conversion device 10 is electrically connected to the neighboring photoelectric conversion device 10 via the connection conductor 7. Accordingly, as shown in FIG. 1, a plurality of photoelectric conversion devices 10 are connected in series to constitute a photoelectric conversion module 20.

The connection conductor 7 connects the second electrode layer 5 and the third electrode layer 6. In other words, the connection conductor 7 connects the second electrode layer 5 of one photoelectric conversion device 10 and the first electrode layer 2 of the other neighboring photoelectric conversion device 10. The connection conductor 7 is formed to divide each of the light-absorbing layers 3 of the neighboring photoelectric conversion devices 10. Accordingly, the electricity photoelectrically converted by the light-absorbing layer 3 can be extracted as a current through series connection. The connection conductor 7 may be formed with the second electrode layer 5 in the same step to be integrated with the second electrode layer 5. This enables to simplify the step of forming the connection conductor 7. Further, the above-mentioned method provides good electrical connection between the connection conductor 7 and the second electrode layer 5, leading to enhanced reliability.

The collector electrode 8 has a function of reducing the electrical resistance of the second electrode layer 5. This allows the current generated in the light-absorbing layer 3 to be extracted efficiently. As a result, power generation efficiency of the photoelectric conversion devices 10 can be increased.

As shown in FIG. 1, for example, the collector electrode 8 is linearly formed from one end of the photoelectric conversion device 10 to the connection conductor 7. Accordingly, the charges generated by photoelectric conversion in the light-absorbing layer 3 are collected by the collector electrode 8 through the second electrode layer 5. The collected charges are conducted to the neighboring photoelectric conversion device 10 through the connection conductor 7. Therefore, the provision of the collector electrode 8 enables to efficiently extract the current generated in the light-absorbing layer 3 even when the second electrode layer 5 is made thinner. This enhances power generation efficiency.

It suffices that the width of the linear collector electrode 8 is, for example, 50 to 400 µm. This enables to achieve conductivity without excessively reducing a light-receiving area of the light-absorbing layer 3. Further, the collector electrode 8 may include a plurality of branch portions.

The collector electrode 8 is formed of, for example, a metal paste obtained by dispersing a powdered metal such as Ag in a resin binder or the like. The collector electrode 8 is formed by, for example, printing a metal paste into a desired pattern shape by screen printing or the like and then curing the metal paste.

The collector electrode 8 may include solder. This enables to enhance the tolerance to a bending stress and reduce a resistance further. The collector electrode 8 may include two or more kinds of metals having different melting points. On this occasion, it suffices that the collector electrode 8 is obtained by melting at least one kind of metal and heating the melted metal at a temperature at which the other at least one kind of metal does not melt and then curing the heated metal. As a result, the metal having a lower melting point melts first, whereby the collector electrode 8 is densified. Accordingly, the resistance of the collector electrode 8 decreases. Meanwhile, the metal having a higher melting point acts so as to keep the shape of the collector electrode 8.

It suffices that the collector electrode 8 is provided so as to reach the peripheral edge of the light-absorbing layer 3 in plan view. In such a manner, the collector electrode 8 can protect the peripheral portion of the light-absorbing layer 3 and reduce the occurrence of chipping in the peripheral portion of the light-absorbing layer 3. The collector electrode 8 as described above is capable of efficiently extracting the current generated in the peripheral portion of the light-absorbing layer 3. This enhances power generation efficiency.

In such a manner, the peripheral portion of the light-absorbing layer 3 can be protected, so that the total thickness of the members provided between the first electrode layer 2 and the collector electrode 8 can be reduced. This enables to reduce the amount of members. Further, the steps of forming the light-absorbing layer 3, the buffer layer 4, and the second electrode layer 5 corresponding to the above-mentioned members can be shortened. It suffices that the total thickness of the light-absorbing layer 3, the buffer layer 4, and the second electrode layer 5 is, for example, 1.56 to 2.7 µm. Specifically, the thickness of the light-absorbing layer 3 is 1 to 2.5 µm. The thickness of the buffer layer 4 is 0.01 to 0.2 µm. The thickness of the second electrode layer 5 is 0.05 to 0.5 µm.

At the peripheral edge of the light-absorbing layer 3, the end surface of the collector electrode 8, the end surface of the second electrode layer 5, and the end surface of the light-absorbing layer 3 may be flush with each other. This enables to extract the current well, which is photoelectrically converted in the peripheral edge of the light-absorbing layer 3. Note that in plan view of the collector electrode 8, the collector electrode 8 does not need to reach the peripheral edge of the light-absorbing layer 3. For example, the occurrence of chipping starting from the peripheral edge of the light-absorbing layer 3 and the progression of the chipping can be reduced if the distance between the peripheral edge of the light-absorbing layer 3 and the end of the collector electrode 8 is 1,000 µm or less.

The present invention is not limited to the embodiments described above, and numerous modifications and variations can be devised in the described aspects without departing from the scope of the invention as defined by the subject-matter of the claims.

### Description of Symbols

- 1: substrate
- 2: first electrode layer (electrode layer)
- 3: light-absorbing layer
- 3a: void
- 4: buffer layer
- 5: second electrode layer
- 6: third electrode layer
- 7: connection conductor
- 8: collector electrode
- 10: photoelectric conversion device
- 20: photoelectric conversion module

## Claims

1. A photoelectric conversion device (10), comprising a light-absorbing layer (3) comprising a chalcopyrite-based compound semiconductor of group I-III-VI and oxygen, wherein the light-absorbing layer comprises voids (3a) therein, and an atomic concentration of oxygen in the vicinity of the voids is higher than an average atomic concentration of oxygen in the light-absorbing layer.

2. The photoelectric conversion device according to claim 1, wherein
the chalcopyrite-based compound semiconductor comprises copper, and
in the light-absorbing layer, an atomic concentration of copper in the vicinity of the voids is lower than an average atomic concentration of copper in the light-absorbing layer.

3. The photoelectric conversion device according to claim 1 or 2, wherein
the chalcopyrite-based compound semiconductor comprises selenium, and
in the light-absorbing layer, an atomic concentration of selenium in the vicinity of the voids is lower than an average atomic concentration of selenium in the light-absorbing layer.

4. The photoelectric conversion device according to claim 1 or 2, wherein
the chalcopyrite-based compound semiconductor comprises selenium, and
in the light-absorbing layer, an atomic concentration of selenium in the vicinity of the voids is higher than an average atomic concentration of selenium in the light-absorbing layer.

5. The photoelectric conversion device according to any one of claims 1 to 4, wherein
the chalcopyrite-based compound semiconductor comprises gallium, and
in the light-absorbing layer, an atomic concentration of gallium in the vicinity of the voids is higher than an average atomic concentration of gallium in the light-absorbing layer.

6. The photoelectric conversion device according to claim 5, wherein the gallium is included as a gallium oxide in the light-absorbing layer.

7. The photoelectric conversion device according to claim 6, wherein the gallium oxide is amorphous.

8. The photoelectric conversion device according to any one of claims 1 to 7, wherein the average atomic concentration of oxygen in the light-absorbing layer is 1 to 3 atomic%.

## Patentansprüche

1. Eine photoelektrische Umwandlungsvorrichtung (10), aufweisend eine Lichtabsorptionsschicht (3), die einen Chalkopyrit-basierten Verbindungshalbleiter der Gruppe I-III-VI und Sauerstoff aufweist,
wobei die Lichtabsorptionsschicht Lücken (3a) darin aufweist und eine Atomkonzentration von Sauerstoff in der Umgebung der Lücken höher als eine durchschnittliche Atomkonzentration von Sauerstoff in der Lichtabsorptionsschicht ist.

2. Die photoelektrische Umwandlungsvorrichtung gemäß Anspruch 1, wobei
der Chalkopyrit-basierte Verbindungshalbleiter Kupfer aufweist und
in der Lichtabsorptionsschicht eine Atomkonzentration von Kupfer in der Umgebung der Lücken niedriger als eine durchschnittliche Atomkonzentration von Kupfer in der Lichtabsorptionsschicht ist.

3. Die photoelektrische Umwandlungsvorrichtung gemäß Anspruch 1 oder 2, wobei
der Chalkopyrit-basierte Verbindungshalbleiter Selen aufweist und
in der Lichtabsorptionsschicht eine Atomkonzentration von Selen in der Umgebung der Lücken niedriger als eine durchschnittliche Atomkonzentration von Selen in der Lichtabsorptionsschicht ist.

4. Die photoelektrische Umwandlungsvorrichtung gemäß Anspruch 1 oder 2, wobei
der Chalkopyrit-basierte Verbindungshalbleiter Selen aufweist und
in der Lichtabsorptionsschicht eine Atomkonzentration von Selen in der Umgebung der Lücken höher als eine durchschnittliche Atomkonzentration von Selen in der Lichtabsorptionsschicht ist.

5. Die photoelektrische Umwandlungsvorrichtung gemäß irgendeinem der Ansprüche 1 bis 4, wobei
der Chalkopyrit-basierte Verbindungshalbleiter Gallium aufweist und
in der Lichtabsorptionsschicht eine Atomkonzentration von Gallium in der Umgebung der Lücken höher als eine durchschnittliche Atomkonzentration von Gallium in der Lichtabsorptionsschicht ist.

6. Die photoelektrische Umwandlungsvorrichtung gemäß Anspruch 5, wobei das Gallium als ein Galliumoxid in der Lichtabsorptionsschicht enthalten ist.

7. Die photoelektrische Umwandlungsvorrichtung gemäß Anspruch 6, wobei das Galliumoxid amorph ist.

8. Die photoelektrische Umwandlungsvorrichtung gemäß irgendeinem der Ansprüche 1 bis 7, wobei die durchschnittliche Atomkonzentration von Sauerstoff in der Lichtabsorptionsschicht 1 bis 3 Atom-% beträgt.

## Revendications

1. Un dispositif de conversion photoélectrique (10), comportant une couche absorbant la lumière (3), comportant un semi-conducteur composé à base de chalcopyrite du groupe I-III-VI et de l'oxygène,
dans lequel la couche absorbant la lumière (3) comprend des vides (3a) là-dedans, et une concentration atomique d'oxygène au voisinage des vides est supérieure à une concentration atomique moyenne d'oxygène dans la couche absorbant la lumière.

2. Le dispositif de conversion photoélectrique selon la revendication 1, dans lequel
le semi-conducteur composé à base de chalcopyrite comprend du cuivre, et
dans la couche absorbant la lumière, une concentration atomique de cuivre au voisinage des vides est inférieure à une concentration atomique moyenne de cuivre dans la couche absorbant la lumière.

3. Le dispositif de conversion photoélectrique selon la revendication 1 ou 2, dans lequel
le semi-conducteur composé à base de chalcopyrite comprend du sélénium, et
dans la couche absorbant la lumière, une concentration atomique de sélénium au voisinage des vides est inférieure à une concentration atomique moyenne de sélénium dans la couche absorbant la lumière.

4. Le dispositif de conversion photoélectrique selon la revendication 1 ou 2, dans lequel
le semi-conducteur composé à base de chalcopyrite comprend du sélénium, et
dans la couche absorbant la lumière, une concentration atomique de sélénium au voisinage des vides est supérieure à une concentration atomique moyenne de sélénium dans la couche absorbant la lumière.

5. Le dispositif de conversion photoélectrique selon l'une quelconque des revendications 1 à 4, dans lequel
le semi-conducteur composé à base de chalcopyrite comprend du gallium, et
dans la couche absorbant la lumière, une concentration atomique de gallium au voisinage des vides est supérieure à une concentration atomique moyenne de gallium dans la couche absorbant la lumière.

6. Le dispositif de conversion photoélectrique selon la revendication 5, dans lequel le gallium est compris comme un oxyde de gallium dans la couche absorbant la lumière.

7. Le dispositif de conversion photoélectrique selon la revendication 6, dans lequel l'oxyde de gallium est amorphe.

8. Le dispositif de conversion photoélectrique selon l'une quelconque des revendications 1 à 7, dans lequel la concentration atomique moyenne d'oxygène dans la couche absorbant la lumière est de 1 à 3 % atomique.
